# EUROPEAN PATENT APPLICATION

(11) **EP 4 746 599 A1**
(43) Date of publication of application: **20.05.2026**
(21) Application number: 24910144.5
(22) Date of filing: 12.10.2024
(51) Int. Cl.: H05K 5/02

(54) **ELECTRONIC DEVICE, AND COMPOSITE BOARD AND PREPARATION METHOD THEREFOR**

(30) Priority: 28.12.2023 CN 202311847818
(71) Applicant: Huawei Technologies Co., Ltd., Shenzhen, Guangdong 518129 (CN)
(72) Inventor: ZHANG, Shijun, Shenzhen, Guangdong 518129 (CN); LI, Heng, Shenzhen, Guangdong 518129 (CN); LIU, Junyan, Shenzhen, Guangdong 518129 (CN); YANG, Qingzhi, Shenzhen, Guangdong 518129 (CN); HU, Lina, Shenzhen, Guangdong 518129 (CN)
(74) Representative: Pfenning, Meinig & Partner mbB
(86) International application number: PCT/CN2024/124529
(87) International publication number: WO 2025/139202

(57) **Abstract**

Embodiments of this application disclose an electronic device, a composite plate, and a preparation method therefor, and relate to the field of plate structures, to improve conductivity of the composite plate. A specific solution includes: The composite plate includes a composite layer, a carbon fiber filament layer, a conductive layer, and a ground plane. The composite layer is provided with a groove structure. The carbon fiber filament layer is buried in the composite layer. A part of the carbon fiber filament layer is located in the groove structure. The conductive layer is stacked with the composite layer. The conductive layer covers at least a part of the groove structure and is electrically connected to the carbon fiber filament layer. A side that is of the conductive layer and that is away from the composite layer is electrically connected to the ground plane. The conductive layer and the carbon fiber filament layer are electrically conducted. The groove structure and the conductive layer are disposed, so that the carbon fiber filament layer buried in the composite layer is electrically connected to the ground plane, all charges on the entire carbon fiber filament layer can flow to the ground plane via the conductive layer, and the entire carbon fiber filament layer has an electromagnetic compatibility protection function. When the composite plate is used in the electronic device, electromagnetic compatibility protection performance of the electronic device can be improved.

## Description

This application claims priority to Chinese Patent Application No. 202311847818.2, filed with the China National Intellectual Property Administration on December 28, 2023 and entitled "ELECTRONIC DEVICE, COMPOSITE PLATE, AND PREPARATION METHOD THEREFOR", which is incorporated herein by reference in its entirety.

### TECHNICAL FIELD

This application relates to the field of plate structures, and in particular, to an electronic device, a composite plate, and a preparation method therefor.

### BACKGROUND

An electronic device (for example, a mobile phone) requires a large quantity of plates. For example, a rear housing or a middle frame of the electronic device is prepared from a plate. Excellent performance of the plate directly affects performance of the electronic device. For example, existing plates all have a problem of poor conductivity. The poor conductivity directly affects use of the plate in the electronic device.

### SUMMARY

Embodiments of this application provide an electronic device, a composite plate, and a preparation method therefor, to improve conductivity of the composite plate.

To achieve the foregoing objective, the following technical solutions are used in this application.

According to a first aspect, an embodiment of this application provides a composite plate. The composite plate includes a composite layer, a first carbon fiber filament layer, a conductive layer, and a ground plane. The composite layer is provided with a groove structure. The first carbon fiber filament layer is buried in the composite layer. A part of the first carbon fiber filament layer is located in the groove structure. The conductive layer is stacked with the composite layer. The conductive layer covers at least a part of the groove structure and is electrically connected to the first carbon fiber filament layer. A side that is of the conductive layer and that is away from the composite layer is electrically connected to the ground plane. In this way, the conductive layer and the first carbon fiber filament layer are electrically conducted. The groove structure and the conductive layer are disposed, so that the first carbon fiber filament layer buried in the composite layer is electrically connected to the ground plane, and all charges on the entire first carbon fiber filament layer can flow to the ground plane via the conductive layer. In addition, the conductive layer covers at least the part of the groove structure and is electrically connected to the first carbon fiber filament layer in the groove structure, so that the entire first carbon fiber filament layer has an electromagnetic compatibility protection function. In addition, the first carbon fiber filament layer has excellent support performance and ductility. The composite plate can make full use of excellent support performance and ductility of the first carbon fiber filament layer to provide support performance for other components, and the composite plate also has an electromagnetic compatibility protection function. When the composite plate is used in an electronic device, electromagnetic compatibility protection performance of the electronic device can be improved.

With reference to the first aspect, in some implementations, the composite plate further includes a second carbon fiber filament layer, buried in the composite layer and stacked with the first carbon fiber filament layer. Arrangement directions of the second carbon fiber filament layer and the first carbon fiber filament layer are not parallel. In this way, the charges can flow between the first carbon fiber filament layer and the second carbon fiber filament layer. The second carbon fiber filament layer may be electrically connected to the ground plane via the conductive layer. The second carbon fiber filament layer and the first carbon fiber filament layer that are not parallel in arrangement direction can increase tensile strength of the composite plate in a plurality of directions.

With reference to the first aspect, in some implementations, the second carbon fiber filament layer is closer to the conductive layer than the first carbon fiber filament layer, and the groove structure penetrates the second carbon fiber filament layer.

With reference to the first aspect, in some implementations, the composite plate further includes a first glass fiber filament layer, buried in the composite layer and stacked with the first carbon fiber filament layer. The first glass fiber filament layer is farther away from the conductive layer than the first carbon fiber filament layer. The first glass fiber filament layer can improve tensile performance of the composite plate. In addition, the first carbon fiber filament layer with excellent conductivity overcomes a problem of the first glass fiber filament layer with poor conductivity, so that the composite plate has electromagnetic compatibility protection performance.

With reference to the first aspect, in some implementations, arrangement directions of the first glass fiber filament layer and the first carbon fiber filament layer are not parallel. Therefore, the composite plate has excellent ductility in the arrangement direction of the first glass fiber filament layer. The composite plate also has excellent ductility in the arrangement direction of the first carbon fiber filament layer.

With reference to the first aspect, in some implementations, the composite plate further includes a second glass fiber filament layer, buried in the composite layer and stacked with the first carbon fiber filament layer. The second glass fiber filament layer is closer to the conductive layer than the first carbon fiber filament layer, and the groove structure penetrates the second glass fiber filament layer. In this way, a connection part of the conductive layer penetrates the second glass fiber filament layer and is electrically connected to the part of the first carbon fiber filament layer. The conductive layer penetrates the second glass fiber filament layer with poor conductivity, so that the first carbon fiber filament layer with the conductivity has an electromagnetic compatibility protection function and an anti-static function, and the support plate has electromagnetic compatibility protection performance and an anti-static function.

With reference to the first aspect, in some implementations, arrangement directions of the second glass fiber filament layer and the first carbon fiber filament layer are not parallel. Therefore, the composite plate has excellent ductility in both the arrangement directions of the second glass fiber filament layer and the first carbon fiber filament layer.

With reference to the first aspect, in some implementations, the composite plate further includes a third carbon fiber filament layer, buried in the composite layer. The third carbon fiber filament layer is stacked on a side that is of the second glass fiber filament layer and that is away from the first carbon fiber filament layer, and the groove structure penetrates the third carbon fiber filament layer. In this way, disposing of the third carbon fiber filament layer can improve the ductility of the support plate. In addition, because the groove structure penetrates the third carbon fiber filament layer, a part of a side wall of the groove structure is formed by the third carbon fiber filament layer. Moreover, because the conductive layer covers the part of the groove structure, the conductive layer also penetrates the third carbon fiber filament layer and is connected to the third carbon fiber filament layer. Therefore, the conductive layer electrically connects the first carbon fiber filament layer to the third carbon fiber filament layer. Existence of the second glass fiber filament layer with the poor conductivity does not affect the electromagnetic compatibility protection performance of the composite plate.

With reference to the first aspect, in some implementations, arrangement directions of the third carbon fiber filament layer and the second glass fiber filament layer are not parallel. In this way, the composite plate has excellent ductility in both the arrangement directions of the third carbon fiber filament layer and the second glass fiber filament layer.

With reference to the first aspect, in some implementations, the composite plate further includes a third glass fiber filament layer, buried in the composite layer. The third glass fiber filament layer and the first carbon fiber filament layer are disposed side by side. In this way, the third glass fiber filament layer can extend a length of the composite layer.

With reference to the first aspect, in some implementations, the conductive layer is a coating or a plating.

With reference to the first aspect, in some implementations, the composite plate further includes a conductive thin film. The conductive thin film is connected to the side that is of the conductive layer and that is away from the composite layer. The ground plane is electrically connected to a side that is of the conductive thin film and that is away from the conductive layer. In this way, the conductive thin film can increase a thickness of a conductive structure on a surface of the support plate. In addition, the conductive thin film and the conductive layer may be formed by using different processes, to provide a plurality of options for preparing the support plate.

According to a second aspect, an embodiment of this application provides a composite plate. The composite plate includes a composite layer, a carbon fiber filament layer, a conductive layer, and a ground plane. The composite layer has a plurality of holes, and the plurality of holes communicate with each other. The carbon fiber filament layer is buried in the composite layer. A part of the carbon fiber filament layer is located in the hole. The conductive layer is stacked with the composite layer. The conductive layer includes a plurality of conductive continuous phase structures. The plurality of conductive continuous phase structures are connected to each other. A part of the conductive continuous phase structure is located in the hole and is electrically connected to the carbon fiber filament layer; and a part of the conductive continuous phase structure is located outside the composite layer and are electrically connected to the ground plane. Therefore, the conductive continuous phase structure of the conductive layer extends into the hole, so that charges on the carbon fiber filament layer are released to the ground plane outside the composite layer, to avoid impact of static electricity generated on the carbon fiber filament layer on another electronic device (for example, an antenna).

With reference to the second aspect, in some implementations, the conductive layer is formed by using a physical vapor deposition process. The conductive continuous phase structure formed by using the physical vapor deposition process may penetrate the hole on the composite layer and is electrically connected to the carbon fiber filament layer, thereby improving electrical performance of the composite plate.

According to a third aspect, an embodiment of this application provides an electronic device. The electronic device includes a printed circuit board and any composite plate provided in the first aspect and the second aspect. The ground plane is disposed on the printed circuit board. Because the composite plate has excellent conductivity and electromagnetic compatibility protection performance, a housing including the composite plate also has electromagnetic compatibility protection performance, so that electrical performance of the electronic device is ensured.

With reference to the third aspect, in some implementations, the electronic device further includes a middle frame, a display, and a rear housing. Both the display and the rear housing are connected to the middle frame, and both the middle frame and the printed circuit board are located between the display and the rear housing. At least one of the middle frame, the display, and the rear housing includes the composite plate.

According to a fourth aspect, an embodiment of this application provides a preparation method for a composite plate, including: forming a groove structure on a surface of a composite layer, where a first carbon fiber filament layer is buried in the composite layer, and a part of the first carbon fiber filament layer is located in the groove structure; coating or plating the surface of the composite layer to form a conductive layer, where the conductive layer is stacked with the composite layer, and the conductive layer covers at least a part of the groove structure and is electrically connected to the first carbon fiber filament layer; and electrically connecting the ground plane to a side that is of the conductive layer and that is away from the composite layer. In this way, according to the preparation method, a position of the groove structure on the composite layer can be accurately located, to accurately obtain a position at which the conductive layer is connected to the first carbon fiber filament layer. The composite plate obtained by using the preparation method has an advantage of accurately locating the groove structure.

With reference to the fourth aspect, in some implementations, before forming the groove structure on the surface of the composite layer, the method further includes: extending the first carbon fiber filament layer into an adhesive to form a prefabricated layer; and curing the prefabricated layer to form the composite layer. A preparation method for the composite layer has a simple process.

With reference to the fourth aspect, in some implementations, extending the first carbon fiber filament layer into the adhesive to form the prefabricated layer includes: extending the first carbon fiber filament layer into the adhesive; and extending a first glass fiber filament layer into the adhesive to form the prefabricated layer. Coating or plating the surface of the composite layer to form the conductive layer includes: coating or plating the surface of the composite layer to form the conductive layer, so that the first glass fiber filament layer is farther away from the conductive layer than the first carbon fiber filament layer. In this way, according to the preparation method, the first glass fiber filament layer may be buried in the composite layer, and disposing of the first glass fiber filament layer does not affect the electrical connection between the conductive layer and the first carbon fiber filament layer.

With reference to the fourth aspect, in some implementations, extending the first carbon fiber filament layer into the adhesive to form the prefabricated layer includes: extending the first carbon fiber filament layer into the adhesive; and extending a second glass fiber filament layer into the adhesive to form the prefabricated layer. Forming the groove structure on the surface of the composite layer includes: forming the groove structure on the surface of the composite layer, so that the groove structure penetrates the second glass fiber filament layer, and the part of the first carbon fiber filament layer is located in the groove structure. In this way, according to the preparation method, the second glass fiber filament layer, the groove structure that penetrates the second glass fiber filament layer, and the conductive layer that covers at least a part of the groove structure may be buried in the composite layer, so that the first carbon fiber filament layer and a circuit outside the composite layer are conducted. This overcomes a problem of poor conductivity of the second glass fiber filament layer.

### BRIEF DESCRIPTION OF DRAWINGS

FIG. 1 is a diagram of a structure of an electronic device;
FIG. 2a is a diagram of a structure of a housing and a printed circuit board of an electronic device;
FIG. 2b is a diagram of a structure of a display and a printed circuit board;
FIG. 3a is a diagram of a structure of a support plate according to an embodiment of this application;
FIG. 3b is a diagram of an exploded structure of the support plate shown in FIG. 3a;
FIG. 3c is a diagram of another structure of a support plate according to an embodiment of this application;
FIG. 4 is a diagram of still another structure of a support plate according to an embodiment of this application;
FIG. 5a is a diagram of yet another structure of a support plate according to an embodiment of this application;
FIG. 5b is a diagram of an exploded structure of a conductive layer and a composite layer in FIG. 5a;
FIG. 6 is a diagram of a structure of a composite layer and a conductive layer according to an embodiment of this application;
FIG. 7 is a diagram of still yet another structure of a support plate according to an embodiment of this application;
FIG. 8 is a diagram of a structure in which a first carbon fiber filament layer and a third glass fiber filament layer are disposed side by side according to an embodiment of this application;
FIG. 9 is a diagram of a further structure of a support plate according to an embodiment of this application;
FIG. 10a is a diagram of another structure of a conductive layer and a composite layer according to an embodiment of this application;
FIG. 10b is an enlarged view at D in FIG. 10a;
FIG. 10c is an enlarged view at E in FIG. 10b;
FIG. 10d is an electron micrograph of a support plate in FIG. 10a;
FIG. 11a is a process flowchart of a composite plate including the support plate in FIG. 4;
FIG. 11b is a diagram of a structure after s1 in FIG. 11a is performed;
FIG. 12a is a process flowchart of forming a composite layer;
FIG. 12b is a diagram of a structure performing s11 in FIG. 12a;
FIG. 12c is a diagram of a structure performing s12 in FIG. 12a;
FIG. 12d is a diagram of a structure performing s13 in FIG. 12a; and
FIG. 12e is a diagram of a structure after s13 in FIG. 12a is performed.

In the figures, 10: electronic device; 11: cover; 12: display; 13: printed circuit board; 14: middle frame; 15: rear housing; 16: side frame; 20: composite plate; 101: ground plane; 100: support plate; 102: auxiliary plate; 103: conductive member; 104: gap; 110: composite layer; 111: groove structure; 112: opening; 113; groove bottom wall; 120: conductive layer; 121: connection part; 122: extension part; 130: first carbon fiber filament layer; 131: first carbon fiber filament; 140: second carbon fiber filament layer; 141: second carbon fiber filament; 150: first glass fiber filament layer; 151: first glass fiber filament; 160: second glass fiber filament layer; 170: third carbon fiber filament layer; 180: fourth glass fiber filament layer; 202: fifth glass fiber filament layer; 201: third glass fiber filament layer; 203: conductive thin film; 210: conductive layer; 211: conductive continuous phase structure; 115: hole; 220: carbon fiber filament layer; 221: carbon fiber filament; 17: adhesive; 18: prefabricated layer; 001: support member; 002: back film; and 003: display panel.

### DESCRIPTION OF EMBODIMENTS

To make objectives, technical solutions, and advantages of this application clearer, the following further describes this application in detail with reference to accompanying drawings.

The terms "first" and "second" mentioned below are merely intended for a purpose of description, and shall not be understood as an indication or implication of relative importance or implicit indication of a quantity of indicated technical features. Therefore, a characteristic limited by "first", "second", or the like may explicitly or implicitly include one or more characteristics. In descriptions of this application, unless otherwise stated, "a plurality of" means two or more than two.

Next, in embodiments of this application, position terms such as "top" and "bottom" are defined relative to positions of components in the accompanying drawings. It should be understood that these directional terms are relative concepts used for relative description and clarification, and may correspondingly change based on changes of positions in which components are placed in the accompanying drawings.

In addition, in embodiments of this application, connection/being connected to may indicate a mechanical connection relationship or a physical connection relationship. To be specific, that A and B are connected to each other or that A is connected to B may indicate that there is a fastening component (like a screw, a bolt, or a rivet) between A and B, or A and B are in contact with each other and it is difficult to separate A from B.

An embodiment of this application provides an electronic device. The electronic device may be a terminal device having an antenna and an electrical connector. The electronic device may be implemented in various forms, including but not limited to a mobile phone, a tablet computer, a desktop computer, a notebook computer, a PDA (personal digital assistant), a wearable device, a display device (such as a television), an information display device, or a smart home terminal. In this embodiment of this application, an example in which the electronic device is a mobile phone is used for description.

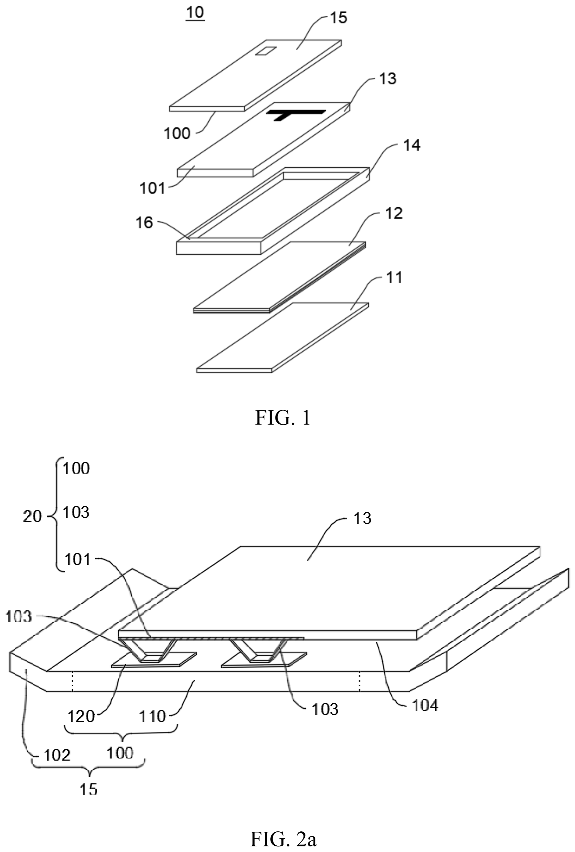

FIG. 1 is a diagram of a structure of an electronic device 10. As shown in FIG. 1, the electronic device 10 may include a cover (cover) 11, a display (display) 12, a printed circuit board (printed circuit board, PCB) 13, a middle frame (middle frame) 14, and a rear housing 15. In some embodiments, the rear housing 15 is also referred to as a rear cover (rear cover). The cover 11, the display 12, and the rear housing 15 are stacked.

The cover 11 may be disposed close to the display 12, and the cover 11 is configured to protect the display 12 and prevent dust. The cover 11 may be cover glass (cover glass), or may be replaced with a cover made of another material, for example, a cover made of an ultra-thin glass material or a cover made of a polyethylene terephthalate (polyethylene terephthalate, PET) material.

The display 12 may include a liquid crystal display (liquid crystal display, LCD) panel, a light-emitting diode (light-emitting diode, LED) display panel, an organic light-emitting diode (organic light-emitting diode, OLED) display panel, or the like. This is not limited in this application. A type of the display 12 includes but is not limited to a dewdrop screen, a notched screen, a bezel-less screen, or a notched screen.

The middle frame 14 has a function of supporting the entire electronic device. The printed circuit board 13 shown in FIG. 1 is disposed between the middle frame 14 and the rear housing 15. It should be understood that, in some embodiments, the printed circuit board 13 may alternatively be disposed between the middle frame 14 and the display 12. This is not limited in embodiments of this application.

For example, the electronic device 10 may further include a battery (not shown in the figure). The battery may be disposed between the middle frame 14 and the rear housing 15, or the battery may be disposed between the middle frame 14 and the display 12. This is not limited in this application.

For example, the printed circuit board 13 carries an electronic component, for example, a radio frequency chip. In some embodiments, components such as an input button, a transmitter, a processor, a memory, a battery, a charging circuit, and a system on chip (system on chip, SoC) structure may be mounted on the printed circuit board 13 or connected to the printed circuit board 13.

In some embodiments, the printed circuit board 13 is divided into a mainboard and a subboard. The battery may be disposed between the mainboard and the subboard. The mainboard may be disposed between the middle frame 14 and an upper edge of the battery, and the subboard may be disposed between the middle frame 14 and a lower edge of the battery.

In some embodiments, the electronic device 10 may further include a side frame 16, and the side frame 16 may be made of a conductive material like metal. The side frame 16 may be disposed between the display 12 and the rear housing 15 and extend circumferentially around a periphery of the display 12. The side frame 16 may have four side edges surrounding the display 12, and the four side edges help fasten the display 12.

In FIG. 1, the side frame 16 is connected to the middle frame 14 to form an integrated component, and the side frame 16 and the middle frame 14 together support the entire electronic device 10. The rear housing 15 and the cover 11 are respectively covered on two opposite sides of the side frame 16 to form a casing or a housing (housing) of the electronic device. In some other embodiments, the side frame 16 and the middle frame 14 may be connected via a spring or a screw, or connected through soldering.

In some embodiments, the rear housing 15, the cover 11, the side frame 16, and the middle frame 14 may be collectively referred to as a casing or a housing of the electronic device 10. It may be understood that the "casing or housing" may be a part or all of any one of the rear housing 15, the cover 11, the side frame 16, and the middle frame 14, or may be a part or all of any combination of the rear housing 15, the cover 11, the side frame 16, and the middle frame 14. In this embodiment of this application, an example in which the rear housing 15 is a housing of the electronic device 10 is used for description.

In some embodiments of this application, the electronic device 10 further includes a ground plane 101. The ground plane 101 may generally be at least a part of any grounding plane, grounding plate, grounding metal layer, or the like in the electronic device (like a mobile phone), or may generally be at least a part of any combination of any grounding plane, grounding plate, grounding component, or the like. The ground plane 101 may be configured to ground an element in the electronic device 10. For example, the ground plane 101 may include a grounding plane of the printed circuit board 13, a grounding metal layer formed by a metal thin film on a side that is of the display 12 and that faces the rear housing 15, a conductive grounding plane of the battery, and a conductive member or a metal member that is electrically connected to the grounding plane/grounding plate/metal layer. In this embodiment of this application, an example in which the ground plane 101 is a grounding plane of the printed circuit board 13 is used for description.

The electronic device 10 further includes a composite plate 20. The composite plate 20 may be disposed on a plurality of parts on the electronic device 10. For example, the composite plate 20 may be disposed on at least one of the rear housing 15, the display 12, and the middle frame 14. In other words, in some embodiments, the rear housing 15 includes the composite plate 20. In some embodiments, the display 12 includes the composite plate 20. In some embodiments, the middle frame 14 includes the composite plate 20. It may be understood that there is no conflict between the rear housing 15 including the composite plate 20, the display 12 including the composite plate 20, and the middle frame 14 including the composite plate 20. The composite plate 20 may be disposed as required based on one or two of the foregoing cases, or the composite plate 20 may be disposed as required based on all of the foregoing cases.

FIG. 2a is a diagram of a structure of a housing and a printed circuit board 13 of an electronic device. In FIG. 2a, the rear housing 15 is electrically connected to a ground plane 101. In other words, the rear housing 15 is grounded to the ground plane 101. Therefore, charges (for example, static electricity) or the like on the rear housing 15 can be discharged to the ground plane 101, to avoid impact of the static electricity on another structure (for example, a display or an antenna). In addition, when a user holds or touches the rear housing 15 of the electronic device, the static electricity on the rear housing 15 is discharged to the ground plane 101, so that the static electricity can be prevented from being discharged to the user, to avoid impact on user experience. In addition, the rear housing 15 is grounded, so that the rear housing 15 has an electromagnetic compatibility (electromagnetic compatibility, EMC) protection function, thereby improving electrical performance of the electronic device. Alternatively, in some embodiments, a partial or entire antenna of the electronic device may be integrated on the rear housing 15, so that the rear housing 15 functions as the antenna.

Because the rear housing 15 is electrically connected to the ground plane 101, a part that is of the rear housing 15 and that is used to connect to the ground plane 101 needs to have conductivity. In some embodiments, the rear housing 15 includes a support plate 100 and an auxiliary plate 102 that are connected. The support plate 100 has conductivity. The support plate 100 is electrically connected to the ground plane 101.

Conductivity of the auxiliary plate 102 is not limited in embodiments of this application. For example, the auxiliary plate 102 has conductivity, or the auxiliary plate 102 may not have conductivity. A manner of connecting the auxiliary plate 102 to the support plate 100 is not limited in embodiments of this application. For example, the auxiliary plate 102 and the support plate 100 are bonded, soldered, screwed, or clamped. In an embodiment in which the auxiliary plate 102 has conductivity, the support plate 100 and the auxiliary plate 102 may be connected to form an integrated component. In other words, the auxiliary plate 102 and the support plate 100 may be considered as a plate structure.

In addition, a relative position between the auxiliary plate 102 and the support plate 100 is not limited in embodiments of this application. For example, the auxiliary plate 102 may be disposed around the support plate 100. Alternatively, the support plate 100 may be disposed around the auxiliary plate 102. Alternatively, the auxiliary plate 102 is located on a side of the support plate 100. Alternatively, the support plate 100 and the auxiliary plate 102 are stacked. In an example in which the support plate 100 and the auxiliary plate 102 are stacked, the support plate 100 may be closer to the ground plane 101 than the auxiliary plate 102, or the support plate 100 may be farther away from the ground plane 101 than the auxiliary plate 102.

The support plate 100 and the auxiliary plate 102 may have a same size or different sizes in a same direction. In an embodiment in which the support plate 100 and the auxiliary plate 102 have different sizes in a same direction, a size of the support plate 100 in the direction may be far greater than a size of the auxiliary plate 102 in the direction; or a size of the support plate 100 in the direction may be far less than a size of the auxiliary plate 102 in the direction.

Shapes of the auxiliary plate 102 and the support plate 100 are not limited in embodiments of this application, and may be adaptively adjusted based on a shape of the electronic device.

It may be understood that the rear housing 15 may further include a structure other than the auxiliary plate 102 and the support plate 100. For example, the rear housing 15 may further include a decorative part, and the decorative part may be connected to the auxiliary plate 102 or the support plate 100. This is not limited in embodiments of this application.

In this embodiment of this application, a composite plate 20 includes the support plate 100 and the ground plane 101. For example, the ground plane 101 may be integrated into the rear housing 15, or the ground plane 101 and the rear housing 15 are disposed independently.

A manner of electrically connecting the support plate 100 to the ground plane 101 is not limited in embodiments of this application. In some embodiments, the support plate 100 abuts against the ground plane 101, so that the support plate 100 and the ground plane 101 can be electrically conducted. In some other embodiments, as shown in FIG. 2a, the composite plate 20 further includes a conductive member 103, and the support plate 100 is electrically connected to the ground plane 101 via the conductive member 103.

A structure of the conductive member 103 is not limited in embodiments of this application. For example, the conductive member 103 may be a conductive sheet, a conductive adhesive layer, conductive foam, a conductive spring, or a conductive bolt.

A quantity of conductive members 103 is not limited in embodiments of this application. For example, there may be one, two, three, four, or more conductive members 103. In an embodiment in which there are a plurality of conductive members 103, the plurality of conductive members 103 are spaced from each other.

In FIG. 2a, there is a gap 104 between the support plate 100 and the ground plane 101. A size and a shape of the gap 104 are not limited in embodiments of this application. In some embodiments, the gap 104 may be configured to accommodate an element of the electronic device, for example, configured to accommodate an element like a camera. It may be understood that, in some embodiments, the gap 104 is not necessary, and the gap 104 may not be disposed. For example, the support plate 100 is attached to the ground plane 101.

In FIG. 2a, the ground plane 101 is located on a side that is of the printed circuit board 13 and that faces the support plate 100. It may be understood that, in another embodiment, the ground plane 101 may be located on a side that is of the printed circuit board 13 and that is away from the support plate 100. This is not limited in embodiments of this application.

In conclusion, the support plate 100 has conductivity. The support plate 100 includes a composite layer 110 and a conductive layer 120, and the conductive layer 120 is connected to the composite layer 110. The conductive layer 120 has conductivity, and a side that is of the conductive layer 120 and that is away from the composite layer 110 is electrically connected to the ground plane 101. For example, the conductive layer 120 is electrically connected to an end that is of the conductive member 103 and that is away from the ground plane 101.

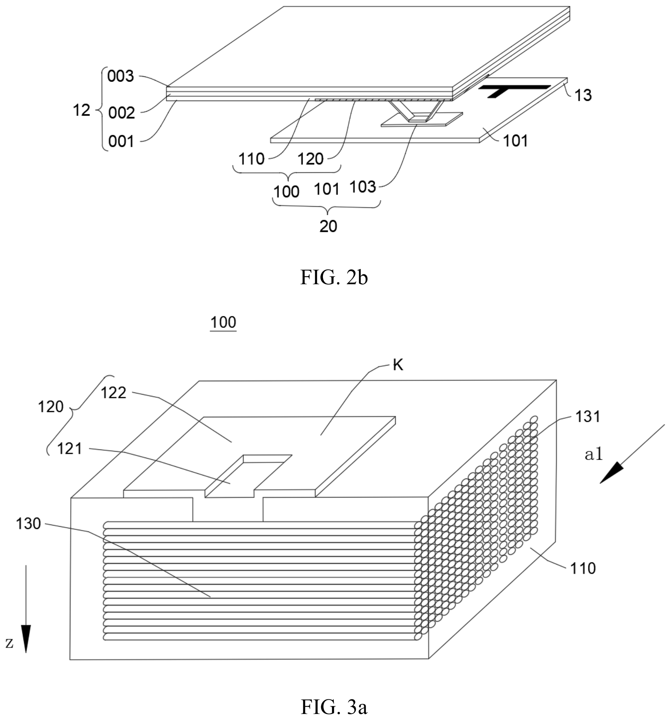

FIG. 2b is a diagram of a structure of a display 12 and a printed circuit board 13. Refer to FIG. 2b. The display 12 includes a support member 001, a back film 002, and a display panel 003. The support member 001, the back film 002, and the display panel 003 are sequentially stacked. The support member 001 is configured to support the back film 002 and the display panel 003. The display panel 003 is configured to emit light, and the back film 002 is configured to protect the display panel 003. In FIG. 2b, the support member 001 includes a composite plate 20. For a structure of the composite plate 20, refer to the description of FIG. 2a. The ground plane 101 in the composite plate 20 is disposed on the printed circuit board 13, and the conductive layer 120 is disposed on a side that is of the composite layer 110 and that is away from the display panel 003.

In FIG. 2b, charges (for example, static electricity) on the display panel 003 may be discharged to the ground plane 101, to avoid impact of the static electricity on the display panel 003. In addition, the composite plate 20 is grounded, so that the support member 001 has an electromagnetic compatibility EMC protection function, thereby improving electrical performance of an electronic device.

In some embodiments, the display 12 may further include a polarizer and a transparent cover. The polarizer is located on a side that is of the display panel 003 and that is away from the back film 002, and the transparent cover is located on a side that is of the polarizer and that is away from the display panel 003.

In this embodiment of this application, the display 12 may be a flexible display or a non-flexible display. In an embodiment in which the electronic device is a foldable device, the display 12 is a flexible display. Therefore, the support member 001 has bendable performance.

This is similar to the relationship between the composite plate 20 and the rear housing 15. In this embodiment of this application, the entire support member 001 is the composite plate 20. In some embodiments, the support member 001 may further include a member in addition to the composite plate 20. For example, the support member 001 may further include a metal plate. The metal plate and the composite plate 20 are disposed side by side, or the metal plate and the composite plate 20 may be stacked. These are not limited in embodiments of this application.

In this embodiment of this application, there are a plurality of examples of the support plate 100.

FIG. 3a is a diagram of a structure of a support plate 100 according to an embodiment of this application. Refer to FIG. 3a. The support plate 100 further includes a first carbon fiber filament layer 130, and the first carbon fiber filament layer 130 is buried in a composite layer 110. A conductive layer 120 and the composite layer 110 are stacked. In this embodiment of this application, for ease of description, a direction in which the conductive layer 120 and the composite layer 110 are stacked is defined as a direction z. In other words, the conductive layer 120 and the composite layer 110 are stacked in the direction z. In FIG. 3a, the direction z is also a thickness direction of the composite layer 110.

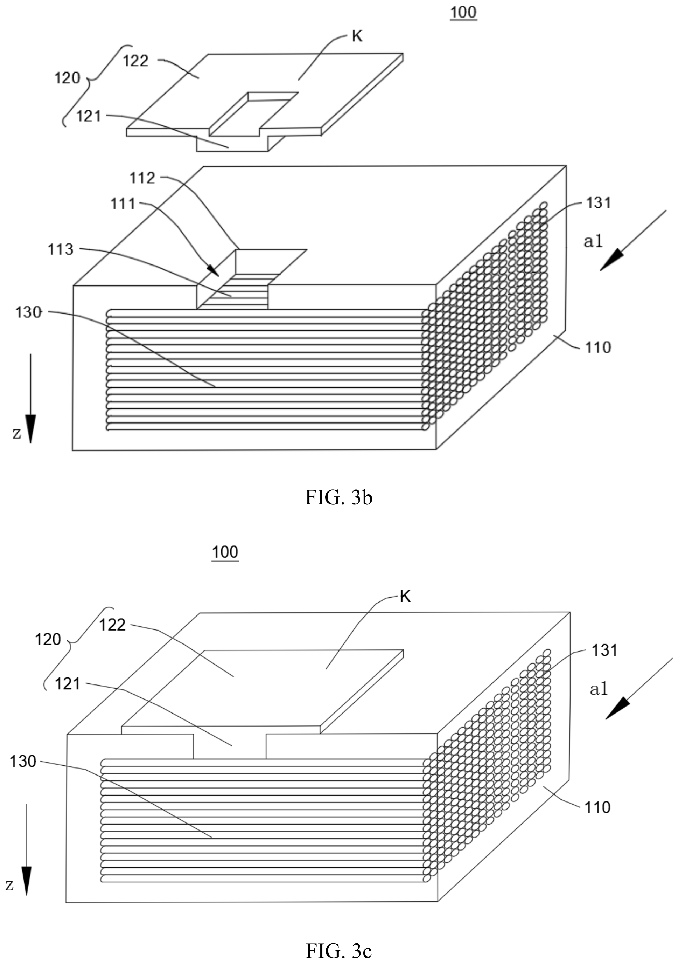

FIG. 3b is a diagram of an exploded structure of the support plate 100 shown in FIG. 3a. Refer to FIG. 3b. The composite layer 110 is provided with a groove structure 111. A part of the first carbon fiber filament layer 130 is located in the groove structure 111. The conductive layer 120 covers at least a part of the groove structure 111 and is electrically connected to the first carbon fiber filament layer 130.

In this way, the conductive layer 120 and the first carbon fiber filament layer 130 are electrically conducted. The groove structure 111 and the conductive layer 120 are disposed, so that the first carbon fiber filament layer 130 buried in the composite layer 110 is electrically connected to the ground plane 101 (as shown in FIG. 2a), and all charges on the entire first carbon fiber filament layer 130 can flow to the ground plane 101 via the conductive layer 120, to prevent static electricity on the first carbon fiber filament layer 130 from affecting electrical performance of another component. In addition, the conductive layer 120 covers at least the part of the groove structure 111 and is electrically connected to the first carbon fiber filament layer 130 in the groove structure 111, and the first carbon fiber filament layer 130 is electrically connected to the ground plane 101, so that the entire first carbon fiber filament layer 130 has an electromagnetic compatibility protection function. In addition, the first carbon fiber filament layer 130 has excellent support performance and ductility. In this embodiment of this application, excellent support performance and ductility of the first carbon fiber filament layer 130 can be fully used to provide support performance for another component (for example, the display 12), and the first carbon fiber filament layer 130 also has an electromagnetic compatibility protection function. In this way, the rear housing 15 (as shown in FIG. 2a) has a plurality of functions.

For example, the first carbon fiber filament layer 130 includes a plurality of arranged first carbon fiber filaments 131. The plurality of arranged first carbon fiber filaments 131 are electrically conducted. In FIG. 2a, an arrangement direction of the first carbon fiber filament layer 130 is a direction a1. In other words, an arrangement direction of the plurality of first carbon fiber filaments 131 is the direction a1. Partial regions of two adjacent first carbon fiber filaments 131 are in contact, and there may be a gap between the partial regions. In some examples, the gap may be filled with an adhesive.

The first carbon fiber filament layer 130 being buried in the composite layer 110 means that all the plurality of arranged first carbon fiber filaments 131 are located in the composite layer 110. It may be understood that a partial region of a first carbon fiber filament 131 located at an edge of the composite layer 110 may be exposed on a surface of the composite layer 110.

The part of the first carbon fiber filament layer 130 being located in the groove structure 111 includes: A partial region of some first carbon fiber filaments 131 in the first carbon fiber filament layer 130 is located in the groove structure 111. A ratio of a size of a part that is of the first carbon fiber filament layer 130 and that is located in the groove structure 111 to a part that is of the first carbon fiber filament layer 130 and that is not located in the groove structure 111 is not limited in embodiments of this application, and may be set based on a shape and a size of the groove structure 111.

A shape of the first carbon fiber filament 131 is not limited in embodiments of this application. The first carbon fiber filament 131 may be a cylindrical, prismatic, or irregular filament. An extension path of the first carbon fiber filament 131 is not limited in embodiments of this application. For example, the extension path of the first carbon fiber filament 131 may be a straight line or a curve.

In some embodiments, a diameter of the first carbon fiber filament 131 is 3 µm (micron) to 5 µm. For example, the diameter of the first carbon fiber filament 131 is 3 µm, 4 µm, or 5 µm. The diameter of the first carbon fiber filament 131 falls within the foregoing range, so that the first carbon fiber filament layer 130 has good ductility. In another embodiment, the diameter of the first carbon fiber filament 131 may not fall within the foregoing range. This is not limited in embodiments of this application.

For example, a maximum distance between two adjacent first carbon fiber filaments 131 is less than or equal to 50 µm. In this way, it is convenient for the charges to move between the two adjacent first carbon fiber filaments 131. Electrostatic charges and the like are more easily transmitted in the first carbon fiber filament layer 130, thereby increasing conductivity of the first carbon fiber filament layer 130. For example, the maximum distance between two adjacent first carbon fiber filaments 131 may be 4 µm, 5 µm, 10 µm, 12 µm, 15 µm, 18 µm, 20 µm, 25 µm, 30 µm, 34 µm, 38 µm, 42 µm, or 50 µm.

For example, the groove structure 111 has an opening 112 and a groove bottom wall 113. The opening 112 is disposed on the surface of the composite layer 110. The opening 112 and the groove bottom wall 113 are disposed opposite to each other. A shape of the opening 112 is not limited in embodiments of this application. For example, the opening 112 may be in a square shape, a circular shape, an oval shape, or an irregular shape. A shape of the groove bottom wall 113 is not limited in embodiments of this application. For example, the groove bottom wall 113 may be in a square shape, a circular shape, an oval shape, or an irregular shape. It may be understood that the opening 112 and the groove bottom wall 113 may have a same shape or different shapes. For example, the opening 112 is in a square shape, and the groove bottom wall 113 may be in an irregular shape, a stepped shape, or the like.

The conductive layer 120 covering at least the part of the groove structure 111 includes: The conductive layer 120 covers the entire groove structure 111. In other words, the entire groove bottom wall 113 of the groove structure 111 is covered by the conductive layer 120. Alternatively, the conductive layer 120 covers a part of the groove structure 111. In other words, a part of the groove bottom wall 113 of the groove structure 111 is covered by the conductive layer 120, and a part of the groove bottom wall 113 is not covered by the conductive layer 120.

For example, the conductive layer 120 includes a connection part 121 and an extension part 122. The connection part 121 is connected to the extension part 122. For example, the connection part 121 and the extension part 122 are connected to form an integrated component. The extension part 122 and the composite layer 110 are stacked in the direction z. The connection part 121 covers at least a part of the groove structure 111 and is electrically connected to the first carbon fiber filament layer 130. It may be understood that, a part that is of the conductive layer 120 and that covers at least the part of the groove structure 111 is named as the connection part 121, and the remaining part is named as the extension part 122.

Relative sizes of the conductive layer 120 and the composite layer 110 are not limited in embodiments of this application. For example, the conductive layer 120 covers an entire surface that is of the composite layer 110 and that faces the conductive layer 120, or the conductive layer 120 covers a part of a surface that is of the composite layer 110 and that faces the conductive layer 120.

In the example in FIG. 3b, a surface K that is of the conductive layer 120 and that is away from the composite layer 110 is not a plane. For example, the surface K that is of the conductive layer 120 and that is away from the composite layer 110 is a concave surface. Alternatively, a surface K that is of the conductive layer 120 and that is away from the composite layer 110 may be a convex surface, a wedge-shaped surface, an irregular plane, or the like. FIG. 3c is a diagram of another structure of the support plate 100 according to an embodiment of this application. In FIG. 3c, a surface K that is of the conductive layer 120 and that is away from the composite layer 110 is a plane. In this way, in FIG. 3c, the connection part 121 of the conductive layer 120 fills the entire groove structure 111, a surface that is of the connection part 121 and that is away from the groove structure 111 and a surface that is of the extension part 122 and that is away from the composite layer 110 are coplanar, and the surface K that is of the conductive layer 120 and that is away from the composite layer 110 is flatter.

For example, a material of the conductive layer 120 includes a conductive material. The conductive material may be any one of the following materials: copper, aluminum, stainless steel, brass, an alloy thereof, graphite powder, or the like. Alternatively, the conductive material may be cured conductive paste, and the conductive paste includes but is not limited to silver paste or copper paste.

A material of the composite layer 110 is not limited in embodiments of this application. For example, the material of the composite layer 110 includes at least one of epoxy resin, a polyurethane adhesive, an acrylic adhesive, and silica gel.

A manner of connecting the conductive layer 120 to the composite layer 110 is not limited in embodiments of this application. For example, the two layers may be bonded via a conductive adhesive. Alternatively, the conductive layer 120 may be formed on the surface of the composite layer 110 and in the groove structure 111 through coating, electroplating, chemical plating, physical vapor deposition (physical vapor deposition, PVD), or the like.

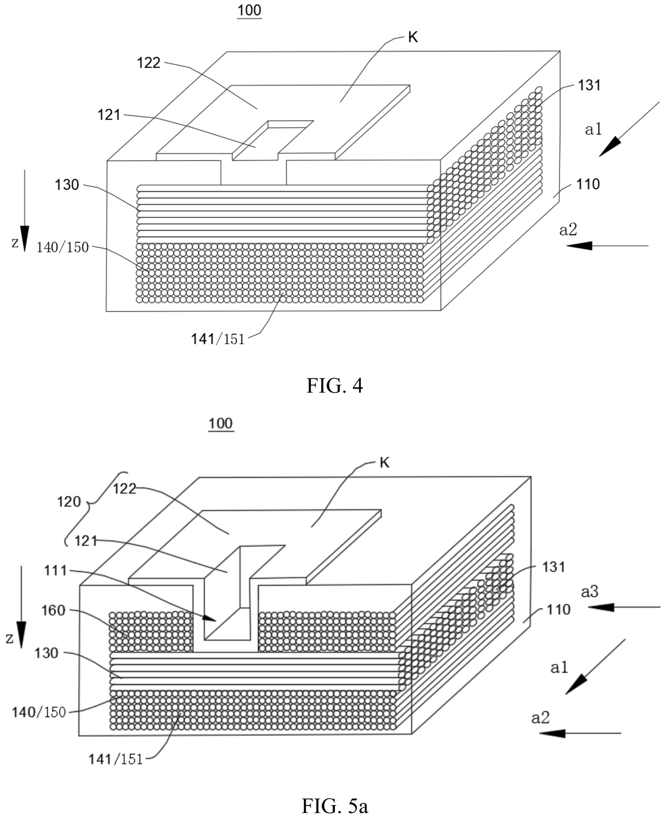

In some embodiments of this application, a second carbon fiber filament layer may be further buried in the composite layer 110. FIG. 4 is a diagram of still another structure of the support plate 100 according to an embodiment of this application. A difference between FIG. 4 and FIG. 3a lies in that the support plate 100 in FIG. 4 may further include the second carbon fiber filament layer 140.

In FIG. 4, the second carbon fiber filament layer 140 and the first carbon fiber filament layer 130 are stacked, and the second carbon fiber filament layer 140 is buried in the composite layer 110. The first carbon fiber filament layer 130 is closer to the conductive layer 120 than the second carbon fiber filament layer 140. In other words, the second carbon fiber filament layer 140, the first carbon fiber filament layer 130, and the conductive layer 120 are sequentially stacked in the direction z. An arrangement direction of the second carbon fiber filament layer 140 is a direction a2. The direction a2 is not parallel to the direction a1.

The second carbon fiber filament layer 140 and the first carbon fiber filament layer 130 are conducted via a circuit. Moreover, because the connection part 121 of the conductive layer 120 is electrically connected to the first carbon fiber filament layer 130, the second carbon fiber filament layer 140 may be electrically conducted with the ground plane 101 (as shown in FIG. 2a) via the conductive layer 120. The second carbon fiber filament layer 140 and the first carbon fiber filament layer 130 that are not parallel in arrangement direction can increase tensile strength of the support plate 100 in a plurality of directions. For example, the support plate 100 has excellent mechanical performance in both the direction a1 and the direction a2.

The second carbon fiber filament layer 140 includes a plurality of second carbon fiber filaments 141. That an arrangement direction of the plurality of second carbon fiber filaments 141 is not parallel to an arrangement direction of the plurality of first carbon fiber filaments 131 in the first carbon fiber filament layer 130 means that a projection of the second carbon fiber filament 141 in the direction z intersects with a projection of the first carbon fiber filament 131 in the direction z.

It may be understood that, in some examples, a part of the second carbon fiber filament 141 may be exposed on a surface that is of the composite layer 110 and that is away from the conductive layer 120. For example, a part of the second carbon fiber filament 141 that is in the second carbon fiber filament layer 140, that is away from the first carbon fiber filament layer 130, and that is in a length direction of the second carbon fiber filament may be allowed to be exposed on the surface that is of the composite layer 110 and that is away from the conductive layer 120. For a structure of the second carbon fiber filament layer 140, refer to the description of the first carbon fiber filament layer 130. Details are not described herein again.

The direction a2 is not parallel to the direction a1. For example, an included angle between the direction a2 and the direction a1 is not 0°. In some embodiments, the included angle between the direction a2 and the direction a1 ranges from 70° to 100°. For example, the included angle between the direction a2 and the direction a1 may be 70°, 75°, 80°, 85°, 88°, 89°, 90°, 92°, 97°, or 100°. The following description that arrangement directions are not parallel is similar to the foregoing description that the arrangement directions of the first carbon fiber filament layer 130 and the second carbon fiber filament layer 140 are not parallel. Details are not described below again.

A size relationship between the second carbon fiber filament layer 140 and the first carbon fiber filament layer 130 in the direction z is not limited in embodiments of this application. For example, sizes of the second carbon fiber filament layer 140 and the first carbon fiber filament layer 130 in the direction z may be equal, or a size of the second carbon fiber filament layer 140 in the direction z may be far greater than or far less than a size of the first carbon fiber filament layer 130 in the direction z. In addition, the second carbon fiber filament 141 and the first carbon fiber filament 131 may have same or different performance such as a size and a shape.

In some other embodiments, the second carbon fiber filament layer 140 may be a first glass fiber filament layer 150. The first glass fiber filament layer 150 includes a plurality of first glass fiber filaments 151. Conductivity of the first glass fiber filament layer 150 is poor, but conductivity of the first carbon fiber filament layer 130 can overcome a problem of poor conductivity of the first glass fiber filament layer 150, so that the support plate 100 has conductivity, and the composite plate 20 (as shown in FIG. 2a) including the support plate 100 has an EMC protection function and an anti-static function. In addition, the first glass fiber filament layer 150 has excellent support performance, and can improve support performance of the support plate 100. Therefore, the support plate 100 including the first glass fiber filament layer 150 and the first carbon fiber filament layer 130 has excellent conductivity and support performance.

An extension path of the first glass fiber filament 151 is not limited in embodiments of this application. For example, the extension path of the first glass fiber filament 151 may be a straight line or a curve. A size of the first glass fiber filament layer 150 in the direction z is not limited in embodiments of this application, and may be set based on a size requirement of the support plate 100 in the direction z.

It may be understood that an arrangement direction of the first glass fiber filament layer 150 and an arrangement direction of the first carbon fiber filament layer 130 may be parallel; or an arrangement direction of the first glass fiber filament layer 150 and an arrangement direction of the first carbon fiber filament layer 130 may not be parallel.

In some embodiments, more layers of structures may be buried in the composite layer 110, to increase a thickness or mechanical strength of the composite layer 110.

FIG. 5a is a diagram of yet another structure of the support plate 100 according to an embodiment of this application. A difference between FIG. 5a and FIG. 4 lies in that the support plate 100 in FIG. 5a further includes a second glass fiber filament layer 160. The second glass fiber filament layer 160 and the first carbon fiber filament layer 130 are stacked in the direction z, and the second glass fiber filament layer 160 is buried in the composite layer 110. The second glass fiber filament layer 160 is closer to the conductive layer 120 than the first carbon fiber filament layer 130. An arrangement direction of the second glass fiber filament layer 160 is a direction a3. The groove structure 111 penetrates the second glass fiber filament layer 160.

As described above, because a part of the first carbon fiber filament layer 130 is located in the groove structure 111, the connection part 121 of the conductive layer 120 covers a part of the groove structure 111 and is electrically connected to a part of the first carbon fiber filament layer 130. The groove structure 111 penetrates the second glass fiber filament layer 160. In this way, the connection part 121 of the conductive layer 120 penetrates the second glass fiber filament layer 160 and is electrically connected to the part of the first carbon fiber filament layer 130. The conductive layer 120 penetrates the second glass fiber filament layer 160 with poor conductivity, so that the first carbon fiber filament layer 130 with conductivity has an EMC protection function and an anti-static function, and the support plate 100 has an EMC protection function and an anti-static function.

In some embodiments, the direction a3 and the direction a1 are not parallel. In this way, the support plate 100 has good ductility in both the direction a3 and the direction a1. In some other embodiments, the direction a3 and the direction a1 may be parallel.

In the example in FIG. 5a, the direction a2 and the direction a3 are parallel. In another embodiment, the direction a2 and the third direction a3 may not be parallel. For example, an included angle between the direction a2 and the direction a3 may be 5° to 30°, for example, 5°, 8°, 10°, 13°, 17°, 20°, 25°, or 30°. Further, in some embodiments, every two of the direction a2, the direction a3, and the direction a1 are not parallel to each other. In this way, the support plate 100 has good ductility in the direction a2, the direction a3, and the direction a1, the support plate 100 has approximately same ductility in a plurality of directions, and mechanical performance of the support plate 100 is improved.

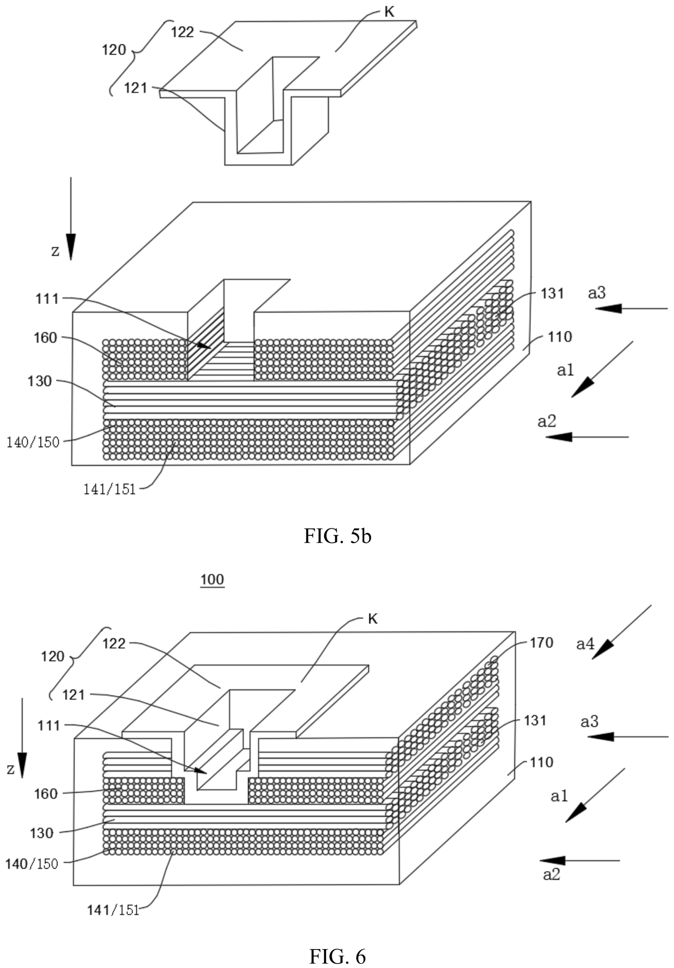

FIG. 5b is a diagram of an exploded structure of the conductive layer 120 and the composite layer 110 in FIG. 5a. In FIG. 5b, the groove structure 111 penetrates the second glass fiber filament layer 160. A part of the first carbon fiber filament 131 in the first carbon fiber filament layer 130 is exposed in the groove structure 111. After extending into the groove structure 111, the connection part 121 of the conductive layer 120 is in contact with the first carbon fiber filament 131 exposed in the groove structure 111, to implement an electrical connection.

It may be understood that, in the example in FIG. 5a, the second carbon fiber filament layer 140 (or the first glass fiber filament layer 150) is not necessary, and the support plate 100 in FIG. 5a may not be provided with the second carbon fiber filament layer 140 (or the first glass fiber filament layer 150).

FIG. 6 is a diagram of a structure of the composite layer 110 and the conductive layer 120 according to an embodiment of this application. A difference between FIG. 6 and FIG. 5a lies in that the support plate 100 in FIG. 6 further includes a third carbon fiber filament layer 170. The third carbon fiber filament layer 170 is buried in the composite layer 110, and the third carbon fiber filament layer 170 is stacked on a side that is of the second glass fiber filament layer 160 and that is away from the first carbon fiber filament layer 130. In other words, the first carbon fiber filament layer 130, the second glass fiber filament layer 160, the third carbon fiber filament layer 170, and the conductive layer 120 are stacked in the direction z. Arrangement directions of the third carbon fiber filament layer 170 and the second glass fiber filament layer 160 are not parallel, and the groove structure 111 penetrates the third carbon fiber filament layer 170 and the second glass fiber filament layer 160.

The arrangement directions of the third carbon fiber filament layer 170 and the second glass fiber filament layer 160 are not parallel. Disposing of the third carbon fiber filament layer 170 can improve ductility of the support plate 100. In addition, because the groove structure 111 penetrates the third carbon fiber filament layer 170, a part of a side wall of the groove structure 111 is formed by the third carbon fiber filament layer 170. The connection part 121 of the conductive layer 120 covers a part of the groove structure 111, and the connection part 121 may also penetrate the third carbon fiber filament layer 170 and is connected to the third carbon fiber filament layer 170. Therefore, the conductive layer 120 electrically connects the first carbon fiber filament layer 130 to the third carbon fiber filament layer 170, and each of the first carbon fiber filament layer 130 and the third carbon fiber filament layer 170 of the support plate 100 have an EMC protection function. In this way, existence of the second glass fiber filament layer 160 with poor conductivity does not affect an EMC protection function of the support plate 100.

In FIG. 6, an arrangement direction of the third carbon fiber filament layer 170 is a direction a4. The direction a4 is not parallel to the arrangement direction a3 of the second glass fiber filament layer 160. In another embodiment, the direction a4 and the direction a3 may alternatively be parallel. A relationship between the direction a4 and the direction a1, and a relationship between the direction a4 and the direction a2 are not limited in embodiments of this application. For example, in FIG. 6, the direction a4 is parallel to the direction a1, and the direction a4 is perpendicular to the direction a2.

A size of a channel formed on the third carbon fiber filament layer 170 by penetrating the third carbon fiber filament layer 170 by the groove structure 111 and a size of a channel formed on the second glass fiber filament layer 160 by penetrating the second glass fiber filament layer 160 by the groove structure 111 are not limited. In the example in FIG. 6, the size of the channel formed on the third carbon fiber filament layer 170 by penetrating the third carbon fiber filament layer 170 by the groove structure 111 is greater than the size of the channel formed on the second glass fiber filament layer 160 by penetrating the second glass fiber filament layer 160 by the groove structure 111, so that the groove structure 111 is in a stepped shape. It may be understood that, in another embodiment, the size of the channel formed by the groove structure 111 on the third carbon fiber filament layer 170 may be equal to the size of the channel formed by the groove structure 111 on the second glass fiber filament layer 160.

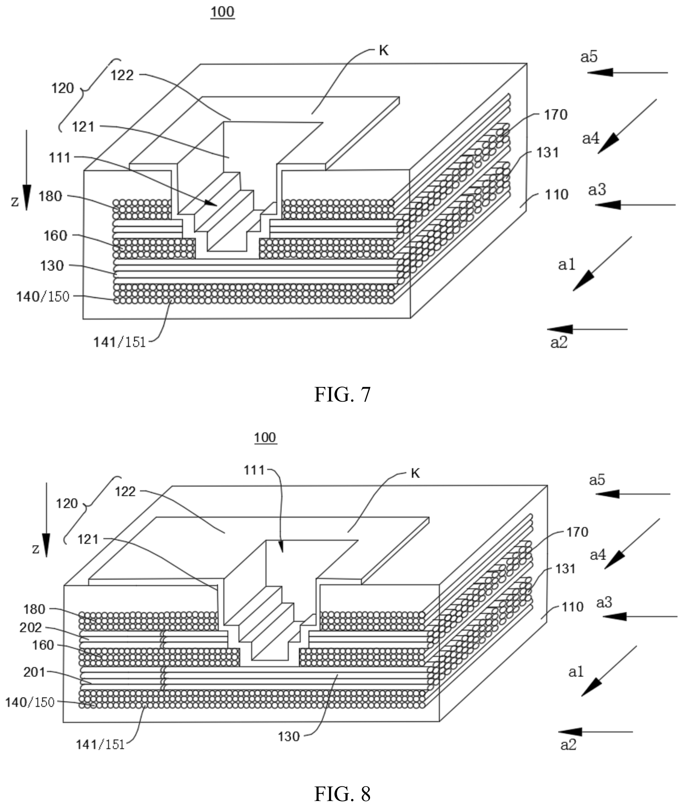

FIG. 7 is a diagram of still yet another structure of the support plate 100 according to an embodiment of this application. A difference between FIG. 7 and FIG. 6 lies in that the support plate 100 in FIG. 7 further includes a fourth glass fiber filament layer 180. The fourth glass fiber filament layer 180 is buried in the composite layer 110, and the fourth glass fiber filament layer 180 is stacked on a side that is of the third carbon fiber filament layer 170 and that is away from the second glass fiber filament layer 160. In other words, the first carbon fiber filament layer 130, the second glass fiber filament layer 160, the third carbon fiber filament layer 170, and the fourth glass fiber filament layer 180 are stacked in the direction z. Arrangement directions of the fourth glass fiber filament layer 180 and the third carbon fiber filament layer 170 are not parallel, and the groove structure 111 penetrates the fourth glass fiber filament layer 180, the third carbon fiber filament layer 170, and the second glass fiber filament layer 160. An arrangement direction of the fourth glass fiber filament layer 180 is a direction a5. The direction a5 is not parallel to the arrangement direction a4 of the third carbon fiber filament layer 170. In another embodiment, the direction a4 and the direction a5 may alternatively be parallel.

Similarly, disposing of the fourth glass fiber filament layer 180 can improve support strength of the support plate 100. In addition, the connection part 121 of the conductive layer 120 penetrates the fourth glass fiber filament layer 180, the third carbon fiber filament layer 170, and the second glass fiber filament layer 160 and is electrically connected to the first carbon fiber filament layer 130. The first carbon fiber filament layer 130 and the third carbon fiber filament layer 170 are electrically conducted via the conductive layer 120, so that the support plate 100 has excellent electrical performance. For example, when the conductive layer 120 is electrically connected to the ground plane 101, charges on the support plate 100 can be released to the ground plane 101, and the support plate 100 can further have an EMC protection function.

Similar to the example in FIG. 6, in FIG. 7, the groove structure 111 may be in a stepped shape, or sizes of cross sections of the groove structure 111 may be the same in the direction z. This is not limited in embodiments of this application.

It may be understood that, similar to the example in FIG. 3c, in the examples in FIG. 4, FIG. 5a, FIG. 6, and FIG. 7, the surface K that is of the conductive layer 120 and that is away from the composite layer 110 may be a plane.

In some embodiments of this application, a carbon fiber filament layer may be spliced with a glass fiber filament layer. In other words, the carbon fiber filament layer and the glass fiber filament layer may be disposed side by side.

FIG. 8 is a diagram of a structure in which the first carbon fiber filament layer 130 and a third glass fiber filament layer 201 are disposed side by side according to an embodiment of this application. A difference between FIG. 8 and FIG. 7 lies in that the support plate 100 in FIG. 8 may further include the third glass fiber filament layer 201. The third glass fiber filament layer 201 is buried in the composite layer 110, and the first carbon fiber filament layer 130 and the third glass fiber filament layer 201 are disposed side by side. In this way, disposing of the third glass fiber filament layer 201 can increase a length of the support plate 100.

In FIG. 8, the extension part 122 of the conductive layer 120 may extend to an orthographic projection of the third glass fiber filament layer 201 on a surface of the composite layer 110. In other words, the extension part 122 of the conductive layer 120 and the third glass fiber filament layer 201 are stacked in the direction z. In this way, the conductive layer 120 can extend to a side of the third glass fiber filament layer 201 with poor conductivity.

On the basis that the first carbon fiber filament layer 130 and the third glass fiber filament layer 201 are disposed side by side, a position relationship between the first carbon fiber filament layer 130 and the third glass fiber filament layer 201 is not limited in embodiments of this application. In some embodiments, the first carbon fiber filament layer 130 is located on a side of the third glass fiber filament layer 201. In some other embodiments, the first carbon fiber filament layer 130 is disposed around the third glass fiber filament layer 201. In some other embodiments, the third glass fiber filament layer 201 is disposed around the first carbon fiber filament layer 130.

A size relationship between the first carbon fiber filament layer 130 and the third glass fiber filament layer 201 is not limited in embodiments of this application. In some embodiments, the first carbon fiber filament layer 130 and the third glass fiber filament layer 201 have a same size in the direction z. In this way, the first carbon fiber filament layer 130 and the third glass fiber filament layer 201 that are disposed side by side are flat.

A relationship between an arrangement direction of the first carbon fiber filament layer 130 and an arrangement direction of the third glass fiber filament layer 201 is not limited in embodiments of this application. For example, the arrangement direction of the first carbon fiber filament layer 130 and the arrangement direction of the third glass fiber filament layer 201 are parallel, or the arrangement direction of the first carbon fiber filament layer 130 and the arrangement direction of the third glass fiber filament layer 201 are not parallel, for example, may be perpendicular.

Similarly, in FIG. 8, the support plate 100 may further include a fifth glass fiber filament layer 202. The fifth glass fiber filament layer 202 is buried in the composite layer 110, and the fifth glass fiber filament layer 202 and the third carbon fiber filament layer 170 are disposed side by side. In this way, disposing of the fifth glass fiber filament layer 202 can increase the length of the support plate 100.

For a relationship between the fifth glass fiber filament layer 202 and the third carbon fiber filament layer 170, refer to the foregoing descriptions about the first carbon fiber filament layer 130 and the third glass fiber filament layer 201. This is not limited in embodiments of this application.

Similarly, in some embodiments, the second carbon fiber filament layer 140 may also be spliced with a glass fiber filament layer. The second glass fiber filament layer 160 and the fourth glass fiber filament layer 180 may also be spliced with a carbon fiber filament layer. Details are not described herein.

In some embodiments, the support plate 100 may be further provided with another conductive structure. The conductive structure is connected to the conductive layer 120, and the conductive structure may be correspondingly adjusted based on a size or position requirement, to meet a plurality of requirements of the support plate 100.

It may be understood that, in some embodiments of this application, the support plate 100 may further include more carbon fiber filament layers or more glass fiber filament layers. In an embodiment in which the support plate 100 includes a plurality of carbon fiber filament layers, a size of the groove structure 111 in a thickness direction of the support plate 100 may be adjusted, so that a carbon fiber filament layer that is in the plurality of carbon fiber filament layers and that is farthest away from the conductive layer 120 is electrically connected to the conductive layer 120, to improve electromagnetic shielding performance of the support plate 100.

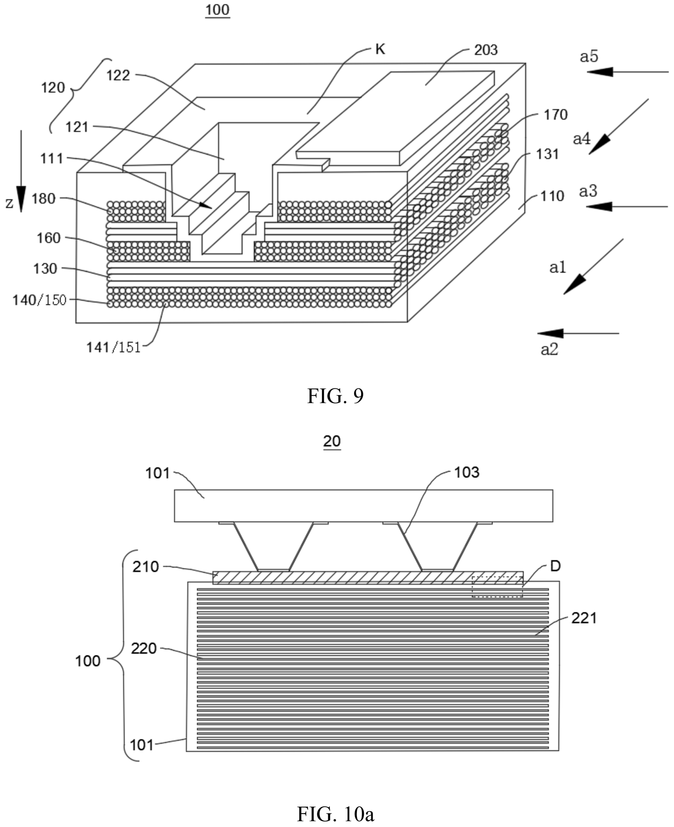

FIG. 9 is a diagram of a further structure of the support plate 100 according to an embodiment of this application. In FIG. 9, the support plate 100 may further include a conductive thin film 203. The conductive thin film 203 is connected to a side that is of the conductive layer 120 and that is away from the composite layer 110, and the ground plane 101 (as shown in FIG. 2a) is electrically connected to the side that is of the conductive thin film 203 and that is away from the conductive layer 120. In this way, the conductive thin film 203 can increase a thickness of a conductive structure on a surface of the support plate 100. In addition, the conductive thin film 203 and the conductive layer 120 may be formed by using different processes, to provide a plurality of options for preparing the support plate 100. For example, the conductive thin film 203 may be connected to the conductive layer 120 via a conductive adhesive layer or a solder layer.

A manner of forming the conductive thin film 203 is not limited in embodiments of this application. For example, the conductive thin film 203 may be formed through forging or molding. Alternatively, the conductive thin film 203 may be formed through coating or plating. In an embodiment in which the conductive thin film 203 and the conductive layer 120 are formed in a same manner, the conductive thin film 203 and the conductive layer 120 may be formed by using one process, that is, the conductive thin film 203 and the conductive layer 120 are connected to form an integrated component. Alternatively, the conductive thin film 203 and the conductive layer 120 may be formed by using two processes. This is not limited embodiments of this application.

A relative position relationship between the conductive thin film 203 and the conductive layer 120 is not limited in embodiments of this application either. For example, the conductive thin film 203 may cover a side that is of the connection part 121 and that is away from the composite layer 110, or the conductive thin film 203 does not cover a side that is of the connection part 121 and that is away from the composite layer 110. In some embodiments, an orthographic projection of the conductive thin film 203 on a surface of the composite layer 110 is located outside an orthographic projection of the conductive layer 120 on the surface of the composite layer 110. In this way, the conductive thin film 203 can increase an area of a conductive region on the surface of the support plate 100.

In some embodiments, the surface of the composite layer 110 has a hole, and a part of the conductive layer 120 may penetrate the hole on the surface of the composite layer 110 and is electrically connected to a carbon fiber layer.

FIG. 10a is a diagram of another structure of the composite plate 20 according to an embodiment of this application. In FIG. 10a, the composite plate 20 includes the ground plane 101 and the support plate 100. The support plate 100 includes the composite layer 110, a carbon fiber filament layer 220, and a conductive layer 210. The carbon fiber filament layer 220 is buried in the composite layer 110. An end that is of the conductive layer 210 and that is away from the composite layer 110 is electrically connected to the ground plane 101. For example, the ground plane 101 is electrically connected to the conductive layer 210 via an electrical connector 103. The carbon fiber filament layer 220 includes a plurality of carbon fiber filaments 221, and the plurality of carbon fiber filaments 221 are disposed side by side.

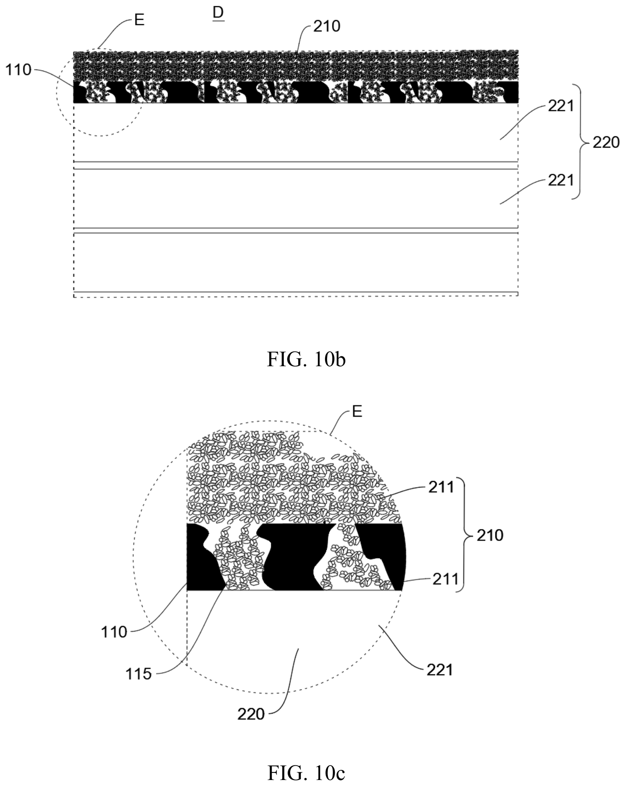

FIG. 10b is an enlarged view at D in FIG. 10a. Refer to FIG. 10b. A part of the conductive layer 210 extends into the composite layer 110, a part of the conductive layer 210 is located outside the composite layer 110, and the part of the conductive layer 210 that extends into the composite layer 110 is electrically connected to the carbon fiber filament layer 220. For example, the carbon fiber filament 221 in the carbon fiber filament layer 220 has excellent conductivity, and the carbon fiber filament layer 220 is electrically connected to the conductive layer 210, so that electrostatic charges and the like on the carbon fiber filament 221 can be transferred to the ground plane 101 (as shown in FIG. 10a).

FIG. 10c is an enlarged view at E in FIG. 10b. Refer to FIG. 10c. The composite layer 110 has a plurality of holes 115, and the plurality of holes 115 communicate with each other. A part of the carbon fiber filament layer 220 is located in the hole 115. The conductive layer 210 includes a plurality of conductive continuous phase structures 211, and the plurality of conductive continuous phase structures 211 are connected to each other. A part of the conductive continuous phase structure 211 is located in the hole 115 and is electrically connected to the carbon fiber filament layer 220; and a part of the conductive continuous phase structure 211 is located outside the composite layer 110 and is electrically connected to the ground plane 101 (as shown in FIG. 10a).

The conductive continuous phase structure includes but is not limited to the following: Metal atoms on a surface of a metal particle diffuse to an interface of an adjacent metal particle and are fused, so that two or more metal particles are fused into an integral structure. A process of forming the atomic diffusion and fusion is not limited in embodiments of this application. For example, the process may be a PVD process.

Therefore, the conductive continuous phase structure 211 of the conductive layer 210 extends into the hole 115, so that charges on the carbon fiber filament layer 220 are released to the ground plane 101 outside the composite layer 110 (as shown in FIG. 10a), to avoid impact of static electricity generated on the carbon fiber filament layer 220 on another electronic device (for example, an antenna). In addition, the composite layer 110 may not be provided with the foregoing groove structure, so that a process flow can be reduced.

Sizes and shapes of the plurality of holes 115 in the composite layer 110 are not limited in embodiments of this application, and are set based on a material and a forming process of the composite layer 110. For example, in an embodiment in which the composite layer 110 includes epoxy resin, the epoxy resin has the foregoing hole 115. It may be understood that the holes 115 may have different shapes and sizes. Similarly, the conductive continuous phase structures 211 of the conductive layer 210 may also have different sizes and shapes. This is not limited in embodiments of this application.

For example, the carbon fiber filament 221 of the carbon fiber filament layer 220 forms an inner wall of the hole 115, and the conductive continuous phase structure 211 located in the hole 115 is attached to the carbon fiber filament 221 in the hole 115, so that the conductive continuous phase structure 211 is electrically connected to the carbon fiber filament 221. Moreover, because the conductive continuous phase structure 211 located outside the composite layer 110 is electrically connected to the conductive continuous phase structure 211 located in the hole 115, electrons on the carbon fiber filament 221 can be transferred to the outside of the composite layer 110 via the conductive continuous phase structure 211.

For example, for a structure of the carbon fiber filament layer 220, refer to the description of the first carbon fiber filament layer 130. For a manner of connecting the conductive layer 210 to the ground plane 101, refer to the description in FIG. 2a. Details are not described herein again.

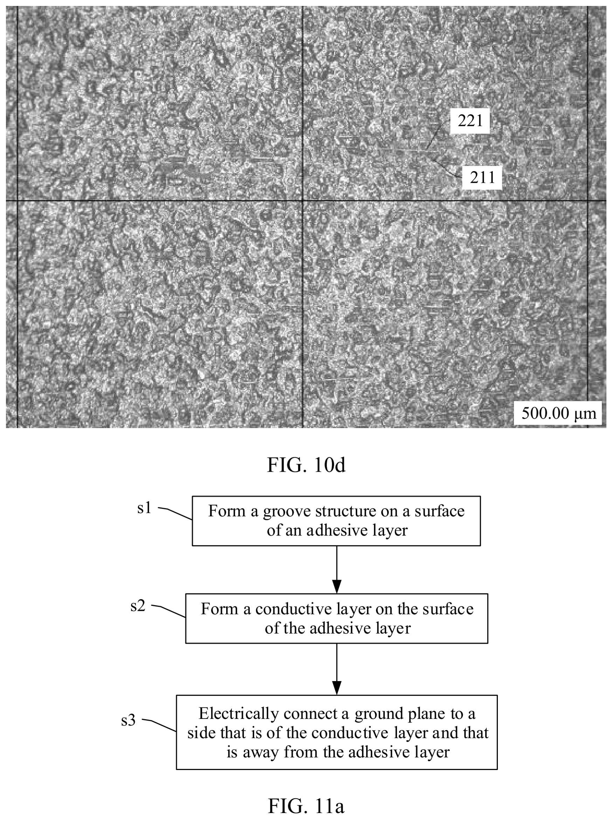

FIG. 10d is an electron micrograph of the support plate in FIG. 10a. The conductive layer in the support plate in FIG. 10d is formed by using a PVD process. It can be seen from FIG. 10d that there are a plurality of carbon fiber filaments 221, and the conductive continuous phase structure 211 is connected to the carbon fiber filament 221. A distance between two adjacent lines in a grid line in FIG. 10d is 500.00 µm.

It may be understood that the composite plate 20 in FIG. 10a may also be provided with the second carbon fiber filament layer 140 (or the first glass fiber filament layer 150) shown in FIG. 4.

In this embodiment of this application, there are a plurality of processes for preparing the composite plate 20. In this embodiment of this application, a process for forming the composite plate 20 including the support plate 100 in FIG. 4 is used as an example for description.

FIG. 11a is a process flowchart of a composite plate including the support plate 100 in FIG. 4. Refer to FIG. 11a. A preparation process for the support plate 100 includes the following steps.

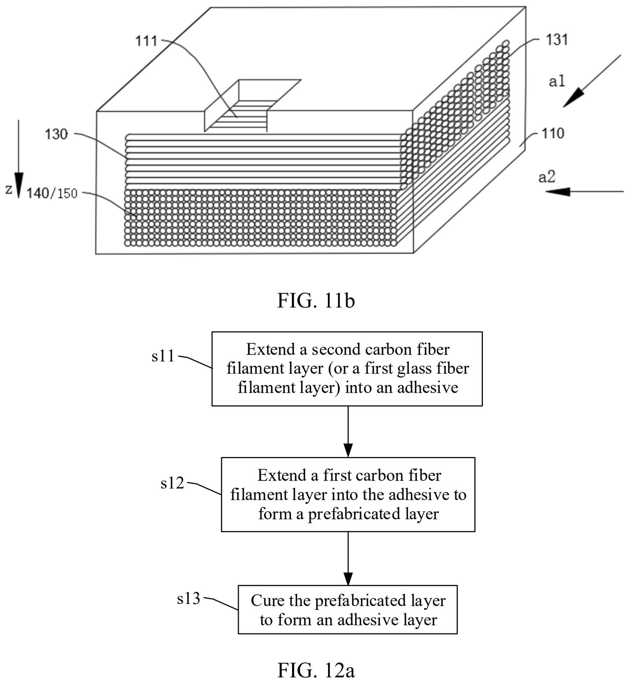

s1: As shown in FIG. 11b, form a groove structure 111 on a surface of a composite layer 110.

FIG. 11b is a diagram of a structure after s1 in FIG. 11a is performed. A first carbon fiber filament layer 130 is buried in the composite layer 110. A part of the first carbon fiber filament layer 130 is located in the groove structure 111. In other words, in a procedure of forming the groove structure 111, the part of the first carbon fiber filament layer 130 buried in the composite layer 110 is exposed in the groove structure 111.

A method for forming the groove structure 111 is not limited in embodiments of this application. For example, the groove structure 111 is formed by using a process like laser engraving, computer numerical control (computer numerical control, CNC) machining, polishing, or sandblasting.

In a procedure of performing s1, a shape of the composite layer 110 is slightly changed when the groove structure 111 is formed. The composite layer 110 with a preset shape may be first selected based on an application scenario of the support plate 100, and then, the groove structure 111 is formed. In addition, the groove structure 111 may be accurately formed on the surface of the composite layer 110, so as to facilitate positioning of the groove structure 111.

In FIG. 11b, a second carbon fiber filament layer 140 may be further buried in the composite layer 110, and the second carbon fiber filament layer 140 is located on a side that is of the first carbon fiber filament layer 130 and that is away from the groove structure 111. Alternatively, a first glass fiber filament layer 150 may be further buried in the composite layer 110, and the first glass fiber filament layer 150 is located on a side that is of the first carbon fiber filament layer 130 and that is away from the groove structure 111.

In this embodiment of this application, the composite layer 110 may be formed in a plurality of manners. The following provides an example of a process for forming the composite layer 110 with reference to FIG. 12a. FIG. 12a is a process flowchart of forming the composite layer 110. In FIG. 12a, the process for forming the composite layer 110 includes the following steps.

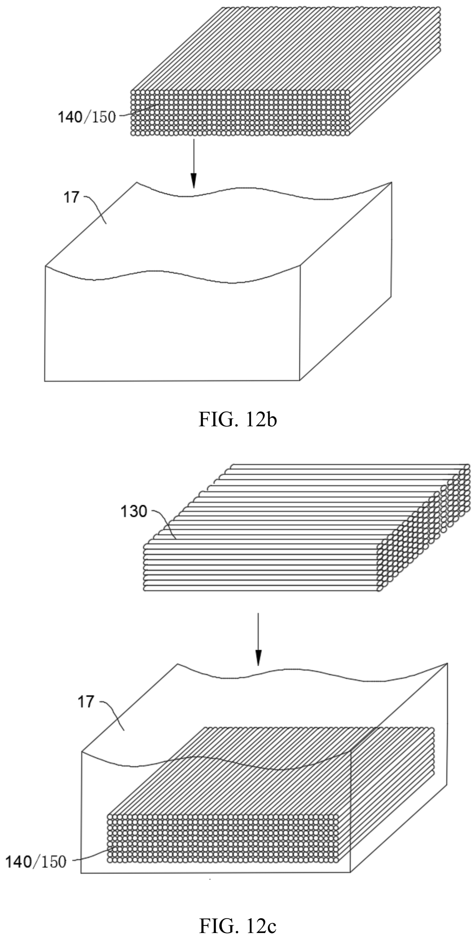

s11: As shown in FIG. 12b, extend the second carbon fiber filament layer 140 (or the first glass fiber filament layer 150) into an adhesive 17.

The second carbon fiber filament layer 140 (or the first glass fiber filament layer 150) includes a plurality of second carbon fiber filaments 141 (or glass fiber filaments 151) disposed side by side. For example, the adhesive 17 is accommodated in a container (not shown in the figure). A material of the adhesive 17 is not limited in embodiments of this application. For example, the material of the adhesive 17 includes epoxy resin.

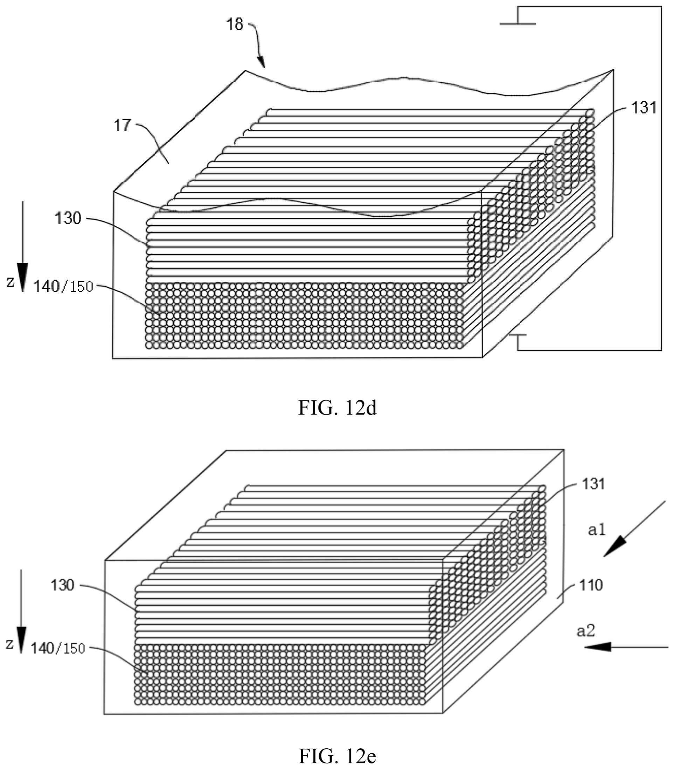

s12: As shown in FIG. 12c, extend the first carbon fiber filament layer 130 into the adhesive 17 to form a prefabricated layer 18 shown in FIG. 12d.

The first carbon fiber filament layer 130 includes a plurality of first carbon fiber filaments 131, and the plurality of first carbon fiber filaments 131 are disposed side by side. An arrangement direction of the first carbon fiber filament layer 130 is not parallel to an arrangement direction of the second carbon fiber filament layer 140 (or the first glass fiber filament layer 150).

The prefabricated layer 18 in FIG. 12d includes the adhesive 17 and the first carbon fiber filament layer 130. The first carbon fiber filament layer 130 is buried in the adhesive 17. The prefabricated layer 18 may further include the second carbon fiber filament layer 140 (or the first glass fiber filament layer 150), and the second carbon fiber filament layer 140 (or the first glass fiber filament layer 150) is buried in the adhesive 17.

In some embodiments, the second carbon fiber filament layer 140 (or the first glass fiber filament layer 150) is not necessary, and s11 may not be performed.

s13: As shown in FIG. 12d, cure the prefabricated layer 18 to form the composite layer 110 shown in FIG. 12e.

FIG. 12e is a diagram of a structure after s13 in FIG. 12a is performed. In FIG. 12e, two layers of structures are buried in the composite layer 110: the first carbon fiber filament layer 130 and the second carbon fiber filament layer 140 (or the first glass fiber filament layer 150). It may be understood that, in some embodiments, the composite layer 110 may further include more layers of structures, for example, a third carbon fiber filament layer and a fourth glass fiber filament layer. A manner of curing the prefabricated layer 18 is not limited in embodiments of this application. For example, the prefabricated layer 18 is cured through compression molding to obtain the composite layer 110.

The example shown in FIG. 12a is merely a process for forming the composite layer 110. It may be understood that, in another embodiment, the composite layer 110 may be formed by using another process.

Refer to FIG. 11a. After s1 is performed, the method further includes the following steps.

s2: Form the conductive layer 120 shown in FIG. 4 on the surface of the composite layer 110.

A structure after s2 in FIG. 11a is performed is shown in FIG. 4. The conductive layer 120 and the composite layer 110 are stacked, and the conductive layer 120 covers at least a part of the groove structure 111 and is electrically connected to the first carbon fiber filament layer 130. For other structures, refer to the description in FIG. 4.

A manner of forming the conductive layer 120 is not limited in embodiments of this application. In some embodiments, the surface of the composite layer 110 is plated, sprayed, or transfer-printed with conductive paste. After the conductive paste is cured, the conductive paste is electrically connected to the first carbon fiber filament layer 130 in the groove structure 111 to implement good conduction. For example, the conductive paste may be silver paste, copper paste, or conductive paint. In some other embodiments, the conductive layer 120 may be formed on the surface of the composite layer 110 by using a plating process.

s3: Electrically connect the ground plane 101 to a side that is of the conductive layer 120 and that is away from the composite layer 110.

A structure after s3 in FIG. 11a is performed is shown in FIG. 2a. In this way, the composite plate 20 can be formed through s1, s2, and s3 in FIG. 11a. The composite plate 20 provided in embodiments of this application has good conductivity. Charges on the composite plate 20 are electrically connected to the ground plane 101, so that the composite plate 20 has an EMC protection function. In addition, static electricity on the composite plate 20 can be discharged to the ground plane 101.

It may be understood that the composite plate 20 including the support plate 100 in FIG. 3a, FIG. 5a, FIG. 6, FIG. 7, or FIG. 8 may also be formed by using the process shown in FIG. 11a. Details are not described herein again.

For example, s1 in FIG. 11a may not be performed in a preparation process for the support plate 100 in FIG. 10a. In other words, the groove structure 111 may not be formed on the composite layer 110. For example, the conductive layer 120 is formed on the surface of the composite layer 110 by using a PVD process, to obtain the support plate 100 shown in FIG. 10a. For other processes, refer to FIG. 11a.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A composite plate, wherein the composite plate comprises:
a composite layer, wherein the composite layer is provided with a groove structure;
a first carbon fiber filament layer, buried in the composite layer, wherein a part of the first carbon fiber filament layer is located in the groove structure;
a conductive layer, stacked with the composite layer, wherein the conductive layer covers at least a part of the groove structure and is electrically connected to the first carbon fiber filament layer; and
a ground plane, electrically connected to a side that is of the conductive layer and that is away from the composite layer.

2. The composite plate according to claim 1, wherein the composite plate further comprises a second carbon fiber filament layer, buried in the composite layer and stacked with the first carbon fiber filament layer, wherein arrangement directions of the second carbon fiber filament layer and the first carbon fiber filament layer are not parallel.

3. The composite plate according to claim 2, wherein the second carbon fiber filament layer is closer to the conductive layer than the first carbon fiber filament layer, and the groove structure penetrates the second carbon fiber filament layer.

4. The composite plate according to any one of claims 1 to 3, wherein the composite plate further comprises a first glass fiber filament layer, buried in the composite layer and stacked with the first carbon fiber filament layer, wherein the first glass fiber filament layer is farther away from the conductive layer than the first carbon fiber filament layer.

5. The composite plate according to any one of claims 1 to 4, wherein the composite plate further comprises a second glass fiber filament layer, buried in the composite layer and stacked with the first carbon fiber filament layer, wherein the second glass fiber filament layer is closer to the conductive layer than the first carbon fiber filament layer, and the groove structure penetrates the second glass fiber filament layer.

6. The composite plate according to claim 5, wherein the composite plate further comprises a third carbon fiber filament layer, buried in the composite layer, wherein the third carbon fiber filament layer is stacked on a side that is of the second glass fiber filament layer and that is away from the first carbon fiber filament layer, and the groove structure penetrates the third carbon fiber filament layer.

7. The composite plate according to any one of claims 1 to 6, wherein the composite plate further comprises a third glass fiber filament layer, buried in the composite layer, wherein the third glass fiber filament layer and the first carbon fiber filament layer are disposed side by side.

8. The composite plate according to any one of claims 1 to 7, wherein the conductive layer is a coating or a plating.

9. The composite plate according to any one of claims 1 to 8, wherein the composite plate further comprises a conductive thin film, the conductive thin film is connected to the side that is of the conductive layer and that is away from the composite layer, and the ground plane is electrically connected to a side that is of the conductive thin film and that is away from the conductive layer.

10. A composite plate, wherein the composite plate comprises:
a composite layer, wherein the composite layer has a plurality of holes, and the plurality of holes communicate with each other;
a carbon fiber filament layer, buried in the composite layer;
a conductive layer, stacked with the composite layer, wherein the conductive layer comprises a plurality of conductive continuous phase structures, the plurality of conductive continuous phase structures are connected to each other, and a part of the conductive continuous phase structure is located in the hole and is electrically connected to the carbon fiber filament layer; and
a ground plane, electrically connected to a part of the conductive continuous phase structure located outside the composite layer.

11. The composite plate according to claim 10, wherein the conductive layer is formed by using a physical vapor deposition process.

12. An electronic device, wherein the electronic device comprises a printed circuit board and the composite plate according to any one of claims 1 to 11, and the ground plane is disposed on the printed circuit board.

13. The electronic device according to claim 12, wherein the electronic device further comprises a middle frame, a display, and a rear housing, wherein both the display and the rear housing are connected to the middle frame, and both the middle frame and the printed circuit board are located between the display and the rear housing; and
at least one of the middle frame, the display, and the rear housing comprises the composite plate.

14. A preparation method for a composite plate, comprising:
forming a groove structure on a surface of a composite layer, wherein a first carbon fiber filament layer is buried in the composite layer, and a part of the first carbon fiber filament layer is located in the groove structure;
coating or plating the surface of the composite layer to form a conductive layer, wherein the conductive layer is stacked with the composite layer, and the conductive layer covers at least a part of the groove structure and is electrically connected to the first carbon fiber filament layer; and
electrically connecting the ground plane to a side that is of the conductive layer and that is away from the composite layer.

15. The preparation method for the composite plate according to claim 14, wherein before forming the groove structure on the surface of the composite layer, the method further comprises:
extending the first carbon fiber filament layer into an adhesive to form a prefabricated layer; and
curing the prefabricated layer to form the composite layer.

16. The preparation method for the composite plate according to claim 15, wherein extending the first carbon fiber filament layer into the adhesive to form the prefabricated layer comprises:
extending the first carbon fiber filament layer into the adhesive; and
extending a first glass fiber filament layer into the adhesive to form the prefabricated layer; and
coating or plating the surface of the composite layer to form the conductive layer comprises:
coating or plating the surface of the composite layer to form the conductive layer, so that the first glass fiber filament layer is farther away from the conductive layer than the first carbon fiber filament layer.

17. The preparation method for the composite plate according to claim 15, wherein extending the first carbon fiber filament layer into the adhesive to form the prefabricated layer comprises:
extending the first carbon fiber filament layer into the adhesive; and
extending a second glass fiber filament layer into the adhesive to form the prefabricated layer; and
forming the groove structure on the surface of the composite layer comprises:
forming the groove structure on the surface of the composite layer, so that the groove structure penetrates the second glass fiber filament layer, and the part of the first carbon fiber filament layer is located in the groove structure.
